# EUROPEAN PATENT APPLICATION

(11) **EP 4 733 281 A1**
(43) Date of publication of application: **29.04.2026**
(21) Application number: 24831861.0
(22) Date of filing: 21.06.2024
(51) Int. Cl.: C03C 14/00, C03C 3/089, C03C 4/16, C03C 10/04, C03C 23/00, C04B 35/14, C04B 41/80, H01L 23/15, H05K 1/03

(54) **INTERPOSER SUBSTRATE, METHOD FOR MANUFACTURING INTERPOSER SUBSTRATE, CORE SUBSTRATE, AND METHOD FOR MANUFACTURING CORE SUBSTRATE**

(30) Priority: 26.06.2023 JP 2023104224; 11.09.2023 JP 2023147064; 11.10.2023 JP 2023176165; 27.02.2024 JP 2024027055
(71) Applicant: Nippon Electric Glass Co., Ltd., Otsu-shi, Shiga 520-8639 (JP)
(72) Inventor: UMAYAHARA Yoshio, Otsu-shi Shiga 520-8639 (JP)
(74) Representative: Henkel & Partner mbB
(86) International application number: PCT/JP2024/022571
(87) International publication number: WO 2025/005000

(57) **Abstract**

To provide an interposer substrate and a core substrate having low dielectric properties (relative dielectric constant and dielectric loss tangent) and high laser processability. An interposer substrate according to the present invention contains a glass and a SiO₂ crystal.

## Description

### TECHNICAL FIELD

The present invention relates to an interposer substrate and a core substrate for connecting semiconductor elements such as a memory chip and a logic chip to a wiring substrate (motherboard) with a coarse wiring pitch.

### BACKGROUND ART

As high functionality of semiconductor products increases, miniaturization of a wiring pattern advances, but as the miniaturization advances, a yield decreases and a manufacturing cost increases. In addition, in a monolithic chip in which all functions are included in one chip, the wiring pattern needs to be matched with a highly functional CPU, which causes an increase in cost. When different types of chips can be mounted on one substrate, chips can be manufactured by an optimum manufacturing process for each chip and mounted on one substrate, so that the cost is reduced. A substrate required for mounting these different types of chips is an interposer substrate and a core substrate.

### CITATION LIST

### PATENT LITERATURE

Patent Literature 1: JP2006-286853A
Patent Literature 2: JP2015-146410A

### SUMMARY OF INVENTION

### TECHNICAL PROBLEM

The interposer substrate and the core substrate are made of a material such as silicon, a resin, and a glass, which have problems (see Patent Literatures 1 and 2). Silicon has a high dielectric loss and is not suitable for mounting a semiconductor for high-frequency applications. The resin has a low dielectric constant but has a larger dielectric loss than inorganic materials. The glass has problems such as cracks occurring in forming a through hole by laser processing.

An object of the present invention is to provide an interposer substrate and a core substrate having low dielectric properties (relative dielectric constant and dielectric loss tangent) and high laser processability.

### SOLUTION TO PROBLEM

As a result of various experiments, the present inventor has found that the above technical problems can be solved by combining a glass and a SiO₂ crystal, and has proposed the present invention. That is, an interposer substrate according to the present invention contains a glass and a SiO₂ crystal.

In the interposer substrate according to the present invention, it is preferable that the glass contains from 0.1% to 2% of Li₂O+Na₂O+K₂O as a composition in mol%, and in molar ratio, Li₂O/(Li₂O+Na₂O+K₂O) is from 0.35 to 0.65, Na₂O/(Li₂O+Na₂O+K₂O) is from 0.25 to 0.55, and K₂O/(Li₂O+Na₂O+K₂O) is from 0.025 to 0.2. Here, "Li₂O+Na₂O+K₂O" refers to the total amount of Li₂O, Na₂O, and K₂O. "Li₂O/(Li₂O+Na₂O+K₂O)" is a value obtained by dividing the content of Li₂O by the total amount of Li₂O, Na₂O, and K₂O. "Na₂O/(Li₂O+Na₂O+K₂O)" is a value obtained by dividing the content of Na₂O by the total amount of Li₂O, Na₂O, and K₂O. "K₂O/(Li₂O+Na₂O+K₂O)" is a value obtained by dividing the content of K₂O by the total amount of Li₂O, Na₂O, and K₂O.

In the interposer substrate according to the present invention, it is preferable that a content of the glass is from 50 mass% to 98 mass% and a content of the SiO₂ crystal is from 2 mass% to 50 mass%.

In the interposer substrate according to the present invention, it is preferable that a content of the glass is from 50 mass% to 96 mass%, a content of the SiO₂ crystal is from 2 mass% to 48 mass%, and a content of cordierite is from 2 mass% to 48 mass%.

The interposer substrate according to the present invention preferably has a thermal expansion coefficient of from 3 ppm/°C to 8 ppm/°C. The "thermal expansion coefficient" refers to a value measured by a thermomechanical analyzer in a temperature range of from 30°C to 380°C.

The interposer substrate according to the present invention preferably has a relative dielectric constant at 16 GHz of from 3.5 to 6.

The interposer substrate according to the present invention preferably has a dielectric loss tangent at 16 GHz of 0.003 or less.

The "relative dielectric constant" and the "dielectric loss tangent" each refer to a value measured at a measurement temperature of 25°C and a frequency of 16 GHz based on a measurement method (JIS R1641) for microwave dielectric properties of a fine ceramic substrate.

A core substrate according to the present invention contains a glass and a SiO₂ crystal.

A method for manufacturing an interposer substrate according to the present invention includes: slip-casting a slurry containing a mixed powder of a glass powder and a SiO₂ crystal powder to obtain a formed body; and then drying and firing the formed body to obtain an interposer substrate.

A method for manufacturing an interposer substrate according to the present invention preferably includes: forming, by laser processing, a through hole in the interposer substrate after firing.

A method for manufacturing a core substrate according to the present invention includes: slip-casting a slurry containing a mixed powder of a glass powder and a SiO₂ crystal powder to obtain a formed body; and then drying and firing the formed body to obtain a core substrate.

A method for manufacturing a core substrate according to the present invention preferably includes: forming, by laser processing, a through hole in the core substrate after firing.

### ADVANTAGEOUS EFFECTS OF INVENTION

According to the present invention, it is possible to provide an interposer substrate and a core substrate having low dielectric properties and high laser processability.

### DESCRIPTION OF EMBODIMENTS

An interposer substrate and a core substrate according to the present invention each contain a glass and a SiO₂ crystal. In a glass, cracks develop in forming a through hole by laser processing, and it is difficult to form a through hole with a high yield. However, in the interposer substrate and the core substrate according to the present invention, since the SiO₂ crystal stops the development of the cracks, the cracks are difficult to occur in forming a through hole, and the through hole can be formed with a high yield. In addition, an amount of debris generated during the laser processing can be reduced. Further, since the SiO₂ crystal has low dielectric properties among ceramics, dielectric properties of the interposer substrate and the core substrate containing the SiO₂ crystal are likely to be low.

As a ceramic powder, a ceramic powder other than the SiO₂ crystal may be introduced. For example, one or two or more selected from β-tridymite, mullite, zirconia, and cordierite can be used. In particular, from the viewpoint of precisely adjusting a thermal expansion coefficient, it is preferable to introduce cordierite. By substituting a part of the SiO₂ crystal with cordierite, only the thermal expansion coefficient can be reduced without changing a glass composition, a relative dielectric constant, and a dielectric loss.

In the interposer substrate and the core substrate according to the present invention, it is preferable that the glass contains from 0.1% to 2% of Li₂O+Na₂O+K₂O as a composition in mol%, and in molar ratio, Li₂O/(Li₂O+Na₂O+K₂O) is from 0.35 to 0.65, Na₂O/(Li₂O+Na₂O+K₂O) is from 0.25 to 0.55, and K₂O/(Li₂O+Na₂O+K₂O) is from 0.025 to 0.2. The reason why the content range of each component is limited as described above will be described below. In the present description, a numerical range indicated using "to" means a range that includes the numerical values listed before and after "to" as the minimum value and the maximum value, respectively.

An alkali metal oxide (Li₂O, Na₂O, or K₂O) is a component that lowers a firing temperature, but is a component that improves the dielectric properties. Therefore, the content of Li₂O+Na₂O+K₂O is preferably from 0.1% to 2%, from 0.1% to 1.5%, from 0.1% to 1%, from 0.1% to less than 1%, from 0.2% to 0.9%, and particularly from 0.3% to 0.8%. Note that, the content of Li₂O is preferably from 0.1% to 1.2%, from 0.1% to 1%, from 0.1% to 0.7%, and particularly from 0.2% to 0.6%. The content of Na₂O is preferably from 0.1% to 0.7%, from 0.1% to 0.6%, from 0.1% to 0.5%, and particularly from 0.2% to 0.4%. The content of K₂O is preferably from 0.01% to 0.3%, from 0.01% to 0.2%, from 0.01% to 0.1%, and particularly from 0.03% to 0.09%.

In order to effectively activate an alkali mixing effect and reduce the dielectric properties, it is preferable that Li₂O/(Li₂O+Na₂O+K₂O) is from 0.35 to 0.65, Na₂O/(Li₂O+Na₂O+K₂O) is from 0.25 to 0.55, and K₂O/(Li₂O+Na₂O+K₂O) is from 0.025 to 0.2 in molar ratio.

In addition to the above components, the following components may be incorporated into the glass composition.

SiO₂ is a component that serves as a network former of the glass. The content of SiO₂ is preferably from 50% to 82%, from 55% to 80%, and particularly preferably from 60% to 78%. When the content of SiO₂ is too small, vitrification is difficult. In addition, it is difficult to obtain low dielectric properties. On the other hand, when the content of SiO₂ is too large, the firing temperature tends to increase.

B₂O₃ is a component that prevents devitrification of the glass during melting. The content of B₂O₃ is preferably from 17% to 30%, from 18% to 30%, from 19% to 30%, from 20% to 30%, and particularly preferably from 21% to 29%. When the content of B₂O₃ is too small, the glass is likely to undergo devitrification. On the other hand, when the content of B₂O₃ is too large, the firing temperature tends to increase.

In addition to the above components, components such as Al₂O₃, MgO, CaO, SrO, BaO, and ZnO may be added up to 3% to the extent that the dielectric properties are not impaired.

The glass having the above composition is likely to have a relative dielectric constant at 16 GHz of from 3.5 to 6, from 3.6 to 5, and particularly from 3.7 to 4.5, and a dielectric loss tangent at 16 GHz of 0.003 or less, 0.0025 or less, and particularly 0.002 or less. When the relative dielectric constant or the dielectric loss tangent of the glass increases, the relative dielectric constant or the dielectric loss tangent of the interposer substrate increases as a result, a loss of a transmission signal is likely to increase, and a speed of signal processing is likely to decrease.

In the interposer substrate and the core substrate according to the present invention, it is preferable that a content of the glass is from 50 mass% to 98 mass% and a content of the SiO₂ crystal is from 2 mass% to 50 mass%, the content of the glass is from 50 mass% to 95 mass% and the content of the SiO₂ crystal is from 5 mass% to 50 mass%, the content of the glass is from 50 mass% to 90 mass% and the content of the SiO₂ crystal is from 10 mass% to 50 mass%, the content of the glass is from 55 mass% to 85 mass% and the content of the SiO₂ crystal is from 15 mass% to 45 mass%, and particularly the content of the glass is from 60 mass% to 80 mass% and the content of the SiO₂ crystal is from 20 mass% to 40 mass%. When the content of a SiO₂ crystal powder is too small, cracks are likely to occur in forming a through hole. On the other hand, when the content of the SiO₂ crystal powder is too large, densification of a fired body is difficult. In addition, since an amount of pores increases and electromagnetic waves are scattered, the dielectric loss tangent is likely to increase.

Examples of the SiO₂ crystal include α-quartz, β-quartz, cristobalite, and tridymite. Note that, the SiO₂ crystal is preferably α-quartz having particularly low dielectric properties.

In the case where the interposer substrate and the core substrate according to the present invention each contain a glass, a SiO₂ crystal, and cordierite, it is preferable that the content of the glass is from 50 mass% to 96 mass%, the content of the SiO₂ crystal is from 2 mass% to 48 mass%, and the content of cordierite is from 2 mass% to 48 mass%, and particularly the content of the glass is from 50 mass% to 93 mass%, the content of the SiO₂ crystal is from 2 mass% to 45 mass%, and the content of cordierite is from 5 mass% to 48 mass%.

In the interposer substrate and the core substrate according to the present invention, the thermal expansion coefficient is preferably from 3 ppm/°C to 8 ppm/°C, and particularly preferably from 3.6 ppm/°C to 6.5 ppm/°C. Accordingly, the thermal expansion coefficient of the interposer substrate and the core substrate is between the thermal expansion coefficient of a semiconductor element (about 3 ppm/°C) and the thermal expansion coefficient of a wiring substrate (from 10 ppm/°C to 15 ppm/°C). Therefore, in the case of applying a heat cycle, a distortion due to a difference in thermal expansion is less likely to occur.

In the interposer substrate and the core substrate according to the present invention, the relative dielectric constant at 16 GHz is preferably from 3.5 to 6, from 3.6 to 5, and particularly preferably from 3.7 to 4.5, and the dielectric loss tangent at 16 GHz is preferably 0.003 or less, 0.0025 or less, and particularly preferably 0.002 or less. Note that, a lower limit of the dielectric loss tangent is not particularly limited, and is realistically 0.0001 or more. When the relative dielectric constant or the dielectric loss tangent increases, the loss of the transmission signal is likely to increase, and the speed of the signal processing is likely to decrease.

Note that, the core substrate is preferably a ceramic core substrate or a glass ceramic core substrate. Accordingly, as described above, cracks are less likely to occur in forming a through hole, and the through hole can be formed with a high yield. In addition, the amount of debris generated during the laser processing can be reduced. Here, the "glass ceramic" is a material containing a glass and a ceramic, and is specifically a composite of a glass and a ceramic or a crystallized glass.

Next, a method for manufacturing an interposer substrate and a core substrate according to the present invention will be described below.

First, predetermined amounts of a binder, a plasticizer, and a solvent are added to a mixed powder of a glass powder and a SiO₂ crystal powder having the above composition to prepare a slurry. Preferred examples of the binder include a polyvinyl butyral resin and a methacrylic acid resin, preferred examples of the plasticizer include dibutyl phthalate, and preferred examples of the solvent include toluene and methyl ethyl ketone.

Note that, an average particle diameter D₅₀ of the SiO₂ crystal powder is preferably 10 µm or less, 8 µm or less, and particularly preferably 5 µm or less. When the average particle diameter D₅₀ of the SiO₂ crystal powder is too large, the effect of preventing the occurrence of cracks in forming a through hole is reduced. In addition, surface smoothness of the interposer substrate is likely to decrease. When a lower limit of the average particle diameter D₅₀ of the SiO₂ crystal powder is too small, the effect of preventing the occurrence of cracks in forming a through hole is reduced. Therefore, the average particle diameter D₅₀ of the SiO₂ crystal powder is preferably 0.01 µm or more, and particularly preferably 0.1 µm or more. Note that, in the present invention, the "average particle diameter D₅₀" refers to a value measured on a volume basis, and indicates a value measured by using a laser diffraction method.

Next, the slurry is formed into a green sheet by using a doctor blade method. Thereafter, the green sheet is dried and cut into a predetermined size, and then a plurality of green sheets are stacked and integrated by thermocompression bonding. Further, the stacked green sheets are fired to obtain an interposer substrate and a core substrate. Note that, the firing temperature is preferably 1000°C or lower, and particularly preferably from 800°C to 950°C.

Note that, although an example in which a green sheet is used has been described as a method for manufacturing an interposer substrate, the present invention is not limited thereto. Various methods generally used for manufacturing a ceramic, such as a method in which a slurry dispersed in water or the like is prepared and a slip casting method is used, can be applied.

The slip casting method will be described in detail. First, 0.1 to 3.0 parts by mass of a water-soluble binder is added to 100 parts by mass of pure water, followed by uniform mixing to obtain a solution. Note that, as the water-soluble binder, water-soluble binders such as acrylic, acrylic styrene, cellulose, polyvinyl alcohol, and polyvinyl acetal binders can be used. To 100 parts by mass of the obtained solution, 70 to 200 parts by mass of a mixed powder of a glass powder and a SiO₂ crystal powder is added, followed by mixing using a mixer such as a planetary mill to obtain a slurry. The obtained slurry is poured into a gypsum mold, and then left for 1 hour to 2 hours to allow the gypsum mold to absorb water, thereby obtaining a formed body. The obtained formed body is taken out from the gypsum mold, dried at 20°C to 60°C for 5 hours to 24 hours, and then fired at 1000°C or lower, particularly at 800°C to 950°C, to obtain an interposer substrate and a core substrate.

In the case where the interposer substrate and the core substrate are required to have smoothness and flatness, polishing is preferably performed. By performing lapping using an alumina abrasive and polishing using a cerium oxide abrasive, a smooth and flat interposer substrate and core substrate can be obtained.

By using a laser processing machine using a carbon dioxide laser, a UV laser, a YAG laser or the like for the interposer substrate and the core substrate after firing, a through hole can be formed in the interposer substrate and the core substrate. Thereafter, electroless copper plating is performed to obtain conduction between upper and lower surfaces.

Note that, since the interposer substrate and the core substrate according to the present invention have high laser processability, the through hole can be formed after firing. By forming the through hole after firing, a through hole having a desired hole diameter can be formed. Note that, when forming a through hole before firing, the hole diameter becomes small during firing, and thus it is difficult to control the hole diameter and to obtain a desired hole diameter.

Fine wiring for semiconductor mounting can be formed by forming a conductor material on the interposer substrate or the core substrate by sputtering, then forming a dry film resist, and performing exposure patterning.

### Example 1

Hereinafter, the present invention will be described based on Examples, but the present invention is not limited to these Examples.

Tables 1 to 3 show Inventive Examples of the present invention (Sample Nos. 1 to 9 and 11 to 13) and Comparative Examples (Sample No. 10). In Tables 1 to 3, "Li+Na+K" means "Li₂O+Na₂O+K₂O", and "Li/(Li+Na+K)", "Na/(Li+Na+K)", and "K/(Li+Na+K)" respectively mean "Li₂O/(Li₂O+Na₂O+K₂O)", "Na₂O/(Li₂O+Na₂O+K₂O)", and "K₂O/(Li₂O+Na₂O+K₂O)".

**Table 1**

| Sample No. | | 1 | 2 | 3 | 4 | 5 |
|---|---|---|---|---|---|---|
| Glass composition (mol%) | SiO₂ | 78.0 | 73.0 | 74.0 | 76.0 | 78.0 |
| | B₂O₃ | 21.2 | 26.02 | 25.5 | 23.7 | 21.2 |
| | Li₂O | 0.32 | 0.49 | 0.25 | 0.18 | 0.32 |
| | Na₂O | 0.4 | 0.39 | 0.225 | 0.105 | 0.4 |
| | K₂O | 0.08 | 0.1 | 0.025 | 0.015 | 0.08 |
| | Li+Na+K | 0.8 | 0.98 | 0.5 | 0.3 | 0.8 |
| Molar ratio | Li/(Li+Na+K) | 0.4 | 0.5 | 0.5 | 0.6 | 0.4 |
| | Na/(Li+Na+K) | 0.5 | 0.4 | 0.45 | 0.35 | 0.5 |
| | K/(Li+Na+K) | 0.1 | 0.1 | 0.05 | 0.05 | 0.1 |

| Dielectric properties of glass | | | | | | |
|---|---|---|---|---|---|---|
| Relative dielectric constant | | 3.8 | 3.8 | 3.7 | 3.7 | 3.8 |
| Dielectric loss tangent | | 0.0010 | 0.0011 | 0.0008 | 0.0006 | 0.0010 |
| Content (mass%) of α-quartz powder | | 28 | 26 | 24 | 20 | 2 |
| Content (mass%) of cordierite powder | | 0 | 0 | 0 | 0 | 23 |
| Firing temperature (°C) | | 850 | 850 | 850 | 840 | 850 |
| Relative dielectric constant | | 3.9 | 3.8 | 3.7 | 3.7 | 3.8 |
| Dielectric loss tangent | | 0.0011 | 0.0012 | 0.0012 | 0.0012 | 0.0013 |
| Thermal expansion coefficient (ppm/°C) | | 6.0 | 5.5 | 5.0 | 4.6 | 3.0 |
| Laser processability | | ○ | ○ | ○ | ○ | ○ |

**Table 2**

| Sample No. | | 6 | 7 | 8 | 9 | 10 |
|---|---|---|---|---|---|---|
| Glass composition (mol%) | SiO₂ | 78.0 | 78.0 | 78.0 | 78.0 | 73.0 |
| | B₂O₃ | 21.2 | 21.2 | 21.2 | 21.2 | 25.0 |
| | Li₂O | 0.32 | 0.32 | 0.32 | 0.32 | 1.1 |
| | Na₂O | 0.4 | 0.4 | 0.4 | 0.4 | 0.6 |
| | K₂O | 0.08 | 0.08 | 0.08 | 0.08 | 0.3 |
| | Li+Na+K | 0.8 | 0.8 | 0.8 | 0.8 | 2.0 |
| Molar ratio | Li/(Li+Na+K) | 0.4 | 0.4 | 0.4 | 0.4 | 0.55 |
| | Na/(Li+Na+K) | 0.5 | 0.5 | 0.5 | 0.5 | 0.3 |
| | K/(Li+Na+K) | 0.1 | 0.1 | 0.1 | 0.1 | 0.15 |

| Dielectric properties of glass | | | | | | |
|---|---|---|---|---|---|---|
| Relative dielectric constant | | 3.8 | 3.8 | 3.8 | 3.8 | 4.1 |
| Dielectric loss tangent | | 0.010 | 0.010 | 0.0010 | 0.0010 | 0.0025 |
| Content (mass%) of α-quartz powder | | 5 | 10 | 15 | 20 | 0 |
| Content (mass%) of cordierite powder | | 20 | 15 | 10 | 5 | 0 |
| Firing temperature (°C) | | 850 | 850 | 850 | 850 | 850 |
| Relative dielectric constant | | 3.8 | 3.8 | 3.8 | 3.8 | - |
| Dielectric loss tangent | | 0.0011 | 0.0012 | 0.0012 | 0.0012 | - |
| Thermal expansion coefficient (ppm/°C) | | 3.4 | 4.2 | 4.7 | 5.0 | 3.5 |
| Laser processability | | ○ | ○ | ○ | ○ | × |

**Table 3**

| Sample No. | | 11 | 12 | 13 |
|---|---|---|---|---|
| Glass composition (mol%) | SiO₂ | 80.0 | 82.0 | 79.0 |
| | B₂O₃ | 19.0 | 17.2 | 20.2 |
| | Li₂O | 0.5 | 0.32 | 0.32 |
| | Na₂O | 0.4 | 0.4 | 0.4 |
| | K₂O | 0.1 | 0.08 | 0.08 |
| | Li+Na+K | 1.0 | 0.8 | 0.8 |
| Molar ratio | Li/(Li+Na+K) | 0.5 | 0.4 | 0.4 |
| | Na/(Li+Na+K) | 0.4 | 0.5 | 0.5 |
| | K/(Li+Na+K) | 0.1 | 0.1 | 0.1 |

| Dielectric properties of glass | | | | |
|---|---|---|---|---|
| Relative dielectric constant | | 3.8 | 3.9 | 3.7 |
| Dielectric loss tangent | | 0.0008 | 0.010 | 0.0011 |
| Content (mass%) of α-quartz powder | | 29 | 27 | 35 |
| Content (mass%) of cordierite powder | | 0 | 0 | 0 |
| Firing temperature (°C) | | 850 | 850 | 850 |
| Relative dielectric constant | | 3.8 | 3.8 | 3.9 |
| Dielectric loss tangent | | 0.0012 | 0.0013 | 0.0013 |
| Thermal expansion coefficient (ppm/°C) | | 6.1 | 6.0 | 6.5 |
| Laser processability | | ○ | ○ | ○ |

First, glass raw materials of various oxides were blended and uniformly mixed so as to have the composition shown in Tables 1 to 3, then the mixture was charged into a platinum crucible and melted at 1550°C to 1650°C for 3 hours to 8 hours, and the molten glass was formed into a thin sheet shape by using a water-cooling roller. Next, the thin sheet was roughly crushed, alcohol was added thereto, the mixture was wet-crushed by using a ball mill, and the crushed materials were classified such that the average particle diameter D₅₀ was from 1.5 µm to 3 µm, thereby obtaining a glass powder. Note that, the relative dielectric constant and the dielectric loss tangent of the glass alone were measured at a measurement frequency of 16 GHz and a temperature of 25°C based on a both-end short-circuit type dielectric resonator method (JIS R1627) using a glass powder press-formed into a cylinder having a diameter of 13 mm and a height of 6.5 mm and then fired at 820°C to 920°C.

Next, for Sample Nos. 1 to 9 and 11 to 13, an α-quartz powder (average particle diameter D₅₀: 2 µm) and a cordierite powder (average particle diameter D₅₀: 2 µm) in the amounts shown in the tables were uniformly mixed with the above glass powder to obtain a mixed powder.

Subsequently, 15 mass% of polyvinyl butyral as a binder, 4 mass% of butyl benzyl phthalate as a plasticizer, and 30 mass% of toluene as a solvent were added to the above mixed powder (glass powder for Sample No. 10) to adjust a slurry. Next, the slurry was formed into a green sheet by using a doctor blade method, dried, and cut into a predetermined size, and then a plurality of sheets were stacked and integrated by thermocompression bonding. Further, the stacked green sheets were fired to obtain an interposer substrate and a core substrate.

The firing temperature, the dielectric properties, the thermal expansion coefficient, and the laser processability of each sample thus obtained were evaluated. The results are shown in Tables 1 to 3.

The firing temperature is the lowest temperature at which an ink is wiped off after the ink is applied to a fired body fired at various temperatures and the ink does not remain (that is, the powder is densely fired).

The relative dielectric constant and the dielectric loss tangent were measured at a measurement frequency of 16 GHz and a temperature of 25°C based on a both-end short-circuit type dielectric resonator method (JIS R1627) using a mixed powder press-formed into a cylinder having a diameter of 13 mm and a height of 6.5 mm and then fired at 820°C to 920°C.

The thermal expansion coefficient was measured by a thermomechanical analyzer in a temperature range of from 30°C to 380°C.

The laser processability was evaluated as follows. Through holes each having a diameter of 100 µm were formed at a pitch of 200 µm on the surface of a measurement sample by using a CO₂ laser processing machine GTW4 for drilling a substrate manufactured by Mitsubishi Electric Corporation. A measurement sample having no cracks was evaluated as "○", and a measurement sample having cracks was evaluated as "×". The laser processing conditions were a wavelength of 9.3 µm, a pulse width of from 1 µs to 5 µs, and percussion processing using a plurality of pulses.

As is clear from Tables 1 to 3, Sample Nos. 1 to 9 and 11 to 13, which are Inventive Examples, have a relative dielectric constant of from 3.7 to 3.9 and a dielectric loss tangent as small as from 0.0011 to 0.0013. In addition, the laser processability is also excellent. On the other hand, Sample No. 10 is poor in laser processability because it does not contain α-quartz.

### Example 2

To 100 parts by mass of pure water, 0.5 parts by mass of an acrylic water-soluble binder was added, followed by uniform mixing to obtain a solution. To 100 parts by mass of the obtained solution, 130 parts by mass of the mixed powder (Sample Nos. 1 to 9 and 11 to 13) was added, followed by mixing using a planetary mill to obtain a slurry. The obtained slurry was poured into a gypsum mold, and then left for 1 hour to allow the gypsum mold to absorb water, thereby obtaining a formed body. The obtained formed body was taken out from the gypsum mold, dried at 40°C for 24 hours, and then fired at 850°C to obtain an interposer substrate and a core substrate.

The firing temperature, the dielectric properties, the thermal expansion coefficient, and the laser processability of each sample thus obtained were evaluated, and the results were the same as in Example 1.

## Claims

1. An interposer substrate comprising: a glass; and a SiO₂ crystal.

2. The interposer substrate according to claim 1, wherein the glass contains from 0.1% to 2% of Li₂O+Na₂O+K₂O as a composition in mol%, and in molar ratio, Li₂O/(Li₂O+Na₂O+K₂O) is from 0.35 to 0.65, Na₂O/(Li₂O+Na₂O+K₂O) is from 0.25 to 0.55, and K₂O/(Li₂O+Na₂O+K₂O) is from 0.025 to 0.2.

3. The interposer substrate according to claim 1 or 2, wherein a content of the glass is from 50 mass% to 98 mass% and a content of the SiO₂ crystal is from 2 mass% to 50 mass%.

4. The interposer substrate according to claim 1 or 2, wherein a content of the glass is from 50 mass% to 96 mass%, a content of the SiO₂ crystal is from 2 mass% to 48 mass%, and a content of cordierite is from 2 mass% to 48 mass%.

5. The interposer substrate according to claim 1 or 2, which has a thermal expansion coefficient of from 3 ppm/°C to 8 ppm/°C.

6. The interposer substrate according to claim 1 or 2, which has a relative dielectric constant at 16 GHz of from 3.5 to 6.

7. The interposer substrate according to claim 1 or 2, which has a dielectric loss tangent at 16 GHz of 0.003 or less.

8. A core substrate comprising: a glass; and a SiO₂ crystal.

9. A method for manufacturing an interposer substrate comprising:
slip-casting a slurry containing a mixed powder of a glass powder and a SiO₂ crystal powder to obtain a formed body; and then
drying and firing the formed body to obtain an interposer substrate.

10. A method for manufacturing an interposer substrate comprising:
forming, by laser processing, a through hole in the interposer substrate according to claim 1 after firing.

11. A method for manufacturing a core substrate comprising:
slip-casting a slurry containing a mixed powder of a glass powder and a SiO₂ crystal powder to obtain a formed body; and then
drying and firing the formed body to obtain a core substrate.

12. A method for manufacturing a core substrate comprising:
forming, by laser processing, a through hole in the core substrate according to claim 8 after firing.
